(19) Europäisches Patentamt
European Patent Office
Office européen des brevets

(11) **EP 3 542 174 B1**

(12) **EUROPEAN PATENT SPECIFICATION**

(45) Date of publication and mention
of the grant of the patent:
**31.05.2023 Bulletin 2023/22**

(21) Application number: **17872049.6**

(22) Date of filing: **17.11.2017**

(51) International Patent Classification (IPC):
**G01R 33/00** *(2006.01)*    **B03C 1/00** *(2006.01)*
**C02F 1/48** *(2023.01)*    C02F 1/46 *(2023.01)*

(52) Cooperative Patent Classification (CPC):
**C02F 1/485; G01R 33/00;** C02F 1/4602;
C02F 2201/483; C02F 2303/22

(86) International application number:
**PCT/IN2017/050539**

(87) International publication number:
**WO 2018/092157 (24.05.2018 Gazette 2018/21)**

(54) **WATER CONDITIONER WITH VARIABLE FREQUENCY ELECTROMAGNETIC FIELD**

WASSERAUFBEREITER MIT ELEKTROMAGNETISCHEM FELD MIT VARIABLER FREQUENZ

CONDITIONNEUR D'EAU AVEC CHAMP ÉLECTROMAGNÉTIQUE À FRÉQUENCE VARIABLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.11.2016 IN 201621039518**

(43) Date of publication of application:
**25.09.2019 Bulletin 2019/39**

(73) Proprietor: **Weismacher Eco Private Limited**
**Ahmedabad, Gujarat 380009 (IN)**

(72) Inventors:
• **ACHARYA, Rajeshkumar Hariprasad**
**Ahmedabad 380 009**
**Gujarat (IN)**
• **SHARMA, Rameshchandra Narayanlal**
**Ahmedabad 380 016**
**Gujarat (IN)**
• **GHADIALI, Yusuf Nazmuddin**
**Ahmedabad 380 001**
**Gujarat (IN)**

(74) Representative: **Plougmann Vingtoft a/s**
**Strandvejen 70**
**2900 Hellerup (DK)**

(56) References cited:
**WO-A1-2006/072125    RU-C1- 2 397 420**
**US-A1- 2013 048 569**

## Description

### Field of the Invention:

The present invention relates to the prevention and removal of deposit of scale and more particularly it relates to an apparatus for preventing and removing deposit of scale in conduits or other hollow bodies which contain water by generating an alternating magnetic field with variable frequency.

### Background of the invention:

Pipes are generally passages through which liquids such as water are induced and moved. Pipes are typically embedded in floors or walls of buildings. As such pipes are used for a relatively long time, various kinds of foreign substances are susceptible to being stuck on the inner surface and thus scales may be produced. The scales may be solidified as time passes and they are the cause for narrow diameter of a pipe passage. Such scale can pose problems with the plumbing in your home. It can form hard deposits of calcium called scale, affecting faucets, shower-heads, dishwashers, and heating elements of water heaters. This can reduce water flow, heating efficiency, and leave spots on dishes. It can also require more soap to get good suds.

A method has been broadly used to remove scale in which water mixed with chemicals passes a pipe whereby the chemicals contact the scale causing a chemical reaction. Such method works with an ion-exchange process wherein the calcium and magnesium in the water is replaced by sodium. As a result, the scale dissolves in water by the chemical reaction. However, it is detrimental to users' health and causes adverse environmental impacts. Further, devices making use of said method need constant replenishment of the chemicals and also require considerable installation work. Hence, people generally desire to adapt a scale remover where no chemicals are used for removing scale.

In order to eliminate the aforesaid chemical solution, the use of magnetic fields has been suggested to prevent scale formation by using magnetic field strengths capable of causing molecular changes or modification of solution properties to prevent the bonding of scale-forming particles. For example, permanent magnets have also been used, but were found to cause the formation of soft sludge over the formation of hard scale that tends to cling to the surface. The effect of scale control is greatly limited by such conditions. However, said permanent magnets loose their magnetism over a period of time and thus their efficiency to remove scale is decreased gradually. Hence, said magnets are required to be replaced over a period of time which is a quite cumbersome process. Further, the build up of debris on the magnets can occlude the pipe and thus reduce the flow of water. Such devices also require considerable installation work.

Inline electro-magnetic systems work like magnetic systems however some of the electro-magnetic systems include oscillation of the magnetic field to offset the permanent polarization effect. In such a conventional magnetic system, said oscillation of magnetic field is performed by using R-L-C circuit. Here, a timer circuit transmits a signal to the R-L-C circuit at irregular time intervals so that an alternating and variable magnetic field is produced within the coil. Here, said timer transmits a signal of limited current thereby producing a magnetic field in the coil of low strength. Further, the transmission of strong signals from the timer causes heating of timer IC. Thus, the effectiveness of the device is therefore limited.

US 2013048569A1 discloses an apparatus for inhibiting scale formation and microorganism growth within a moving water system, with the apparatus including: (i) a pulse-power assembly having a fly-back pulse generator circuit effective to produce a current pulse that when terminated yields a voltage spike and generates a plurality of frequencies of energy, where the fly-back pulse generator circuit comprises a coil as an integral portion of the fly-back pulse generator circuit; and (ii) a chamber for passing water from the moving water system therethrough, where the coil is wound around the chamber so as to transmit the plurality of frequencies of energy into the chamber in order to inhibit scale formation and microorganism growth within the moving water system. Water treatment systems and methods of using the apparatus are also provided.

Hence, it is long standing problem in the art to produce alternating magnetic field of desire strength without causing the problem of overheating the circuit.

### Object of the Invention:

The main object of present invention is to provide a water scale removal and prevention device that resolve the problems set forth in the prior art.

Another object of present invention is to provide a water scale removal and prevention device that provides a chemical free solution for removing scale.

Further object of present invention is to provide a water scale removal and prevention device that has the capability to remove scale from the water carrying apparatus i.e. a pipe as well as a water storing means i.e. a tank.

A further object of the present invention is to provide a water scale removal and prevention device that efficiently removes scale and that prevents the formation of scale in the water carrying apparatus by producing an alternating magnetic field with a variable frequency.

Yet another object of present invention is to provide a water scale removal and prevention device that overcomes the problem of circuit overheating and that produces a strong magnetic field.

### Summary of the Invention:

The invention is defined in the annexed claims.

The present invention relates to an apparatus for removing scale and preventing the formation of scale in water supply line. Said apparatus comprises a switched mode power supply for generating a DC voltage signal between its positive terminal and its negative terminal, at least one signal wire wound around a pipe such that two overlapping coils of optimum number of turns are formed on the pipe, said pipe being configured such that it can be retrofitted or incorporated into a metallic pipe wherein scale is to be removed or the formation of scale is to be prevented. The apparatus further comprises a transistor having a low operating frequency and three terminals. Said signal wire has a two conductor leads that are electrically connected between two selective terminals of the transistor. The center tap formed between said overlapping coils is connected to a positive terminal of the SMPS. Thus, said signal from positive terminal is passed through the coil and the transistor and is received to the negative terminals of the SMPS. When said signal is communicated to the coil, an electromagnetic field is produced surrounding to the coil. Here, said signal is interrupted at irregular time intervals by said transistor causing the production of an alternative electromagnetic field with a variable frequency. Said noncontinuous electromagnetic field effectively removes and Prevents the formation of scale in the water carrying pipes.

**Brief Description of the drawings**

Objects and advantages of the invention will be apparent from the following detailed description taken in conjunction with the accompanying figures wherein:

Fig. 1 shows a block diagram of first embodiment of an apparatus for removal and prevention of scale deposition according to present invention.

Fig. 2 shows a block diagram of an apparatus, which can be used advantageously in connection with the present invention, for removal and prevention of scale deposition according to present invention.

**Detailed description of the invention**

Before explaining the present invention in detail, it is to be understood that the invention is not limited in its application to the details of the construction and arrangement of parts illustrated in the accompany drawings. The invention is capable of other embodiments, as depicted in different figures as described above and of being practiced or carried out in a variety of ways. It is to be understood that the phraseology and terminology employed herein is for the purpose of description and not of limitation. The extend of the present invention is determined by the attached claims.

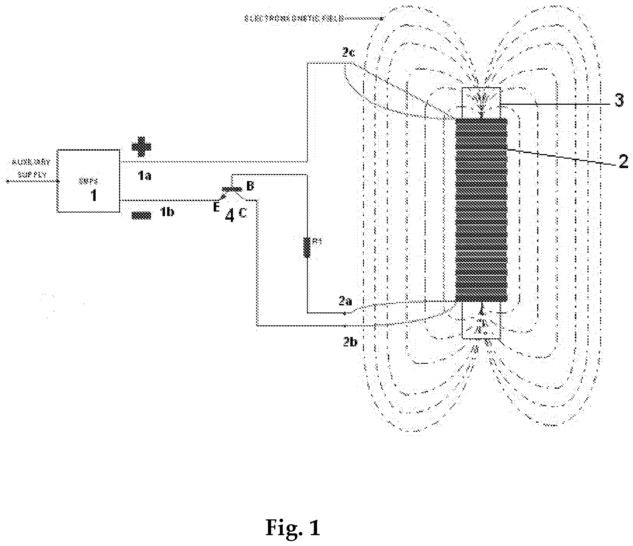

Referring to Fig. 1, an apparatus for preventing scaling and/or removing scale in a housing (not shown) is shown. Although not shown in the drawings, the housing in this embodiment is a metallic or a non-metallic pipe configured to carry water. The apparatus of the present invention, however, may be applied to other containers including conduits or tanks used to carry water such as hard water that can cause scaling.

Referring to Fig. 1, there is provided a diagram of a first embodiment of apparatus for scale removal and scale prevention which comprise a SMPS (switched mode power supply) (1) having a positive terminal (1a) and a negative terminal (1b) and capable of generating a DC voltage signal between said terminals (1a, 1b) from an auxiliary power supply, a pipe section (3), preferably made from copper or plastic, a signal cable (2) having a first conductor lead (2a) and a second conductor lead (2b) which is shown coiled around the outer surface of the pipe section (3) and a NPN transistor (4), preferably TTC5200, having terminals B, C and E. The conductor leads (2a, 2b) of said signal cable (2) are respectively connected to the terminals B and C of the transistor (4) and remaining terminal E is connected to a negative terminal (1b) of the SMPS (1) as shown in Fig. 1. The pipe section (3) is configured such that it is retrofittable or incorporable into the housing pipe. Once installed, opposing ends of the pipe section (3) adjoin to the respective openings of the housing pipe such that the plastic pipe section (3) and the housing pipe are in fluidly communication with one another.

It is to be noted that said pipe section (3) is preferably made from the copper or plastic material. Further, the purpose of using the TTC5200 NPN transistor is to make use of its characteristic of low operating frequency which is suitable for varying the frequency of the magnetic field generated in the coil. However, it is within the scope of present invention to utilize other transistors having a similar configuration as the TTC5200. Further, it is within the scope of present invention to replace the SMPS with a battery for producing the DC voltage signal.

Referring continuous to Fig. 1, there is shown a configuration of winding said signal cable (2) on the pipe (3). Said signal cable (2) is wound such that when about half of the length of the signal cable (2) is coiled on the pipe (3) to form a first coil by winding optimum number of turns, a center tap (2c) is formed by extending and banding some portion of the signal cable (2). Another half portion of the signal cable is coiled on the pipe (3) in a reverse linear direction to form a second coil. Thus, two overlapping coils are formed on the pipe (3) that contains about similar number of turns.

Now, referring Fig. 1 again, said center tap (2c) is electrically connected to the positive terminal (1a) of the SMPS (1). In said embodiment, the first conductor lead (2a) of signal cable (2) is connected to the terminal B via resistor R1 for limiting the base current flow and the second conductor lead (2b) of signal cable (2) is connected to the terminal C of the transistor (4). Said terminal E of the transistor (4) is connected to the negative terminal (1b) of the SMPS (1). Here, said DC signal applied to the signal cable (2) produces an electromagnetic field (shown in dotted line) by completing the circuitry from the positive terminal (1a) to the negative terminal (1b). The aforesaid configuration enables the transistor (4) to come in the path of said DC signal during flowing from the positive terminal (1a) to the negative terminal (1b).

In operation, a standard AC power supply is given to the input of the SMPS (1) that produces a stable DC voltage signal between said positive terminal (1a) and negative terminal (1b). Now, when said signal is applied to the center tap (2c) of signal cable (2), said coils are energized to produce an alternating magnetic field wherein lines of flux of magnetic field produced from one coil are directed along the fluid flow path established by said pipe (3) and the lines of flux of magnetic field produced from another (second) coil are directed to the opposite direction of fluid flow path. Thus, an alternating magnetic field is produced in the coils. From centre tap (2c), said current is divided by flowing through the conductor leads (2a, 2b). Here, said current is applied to the terminal B from the first conductor lead (2a) by passing through the resistor R1 that controls the current of said signal. Similarly, said signal is applied to the terminal C by second conductor lead (2b) without using any current limiting component in its path. Due to the low operating frequency of the transistor (4), said signal will alternatively pass from the terminal B to terminal E and terminal C to terminal E. Here in both case, magnetic fields of different values are produced in the coils which is shown below.

In first embodiment, the magnetic field is calculated in the overlapping coils on the pipe by passing the signal of 0.26amp in both coils. Each said coil contains N=100 turns wound on the L=0.06m length of pipe section (3). The magnetic field produced in both coils is calculated below.

In first coil, said signal is passed through the resistor of R1=6.6K whereby the current is reduced up to $0.8*10^{-3}$ amp. Thus according to equation, a

$$B1= 4\ \Pi*10^{-7}*100*0.8*10^{-3} / 0.06$$
$$= 1.67\mu T$$

magnetic field is produced.

In second coil, according to equation, a

$$B2= 4\ \Pi*10^{-7}*100*0.26 / 0.06$$

= 0.544mT magnetic field is produced.

By comparing the magnetic fields induced in both coils, it is seen that an alternating magnetic field with variable frequency is generated in the coils at different time intervals by using said transistor. The frequency of magnetic field is varied in the range of 360 Hz to 3.70 kHz. Here, said magnetic fields

B1 and B2 will be in opposite direction. Further, said transistor is equipped with heat sink that keeps said transistor cool.

Moreover, by increasing the current, the value of magnetic field in each coil is increased without causing any problem of overheating. Thus, an electro-magnetic field of desired strength is achieved in the coils. Further, the heat of entire circuit is also dissipated by the cooling fan (not shown) that is operated by said DC signal or any other external power supply means.

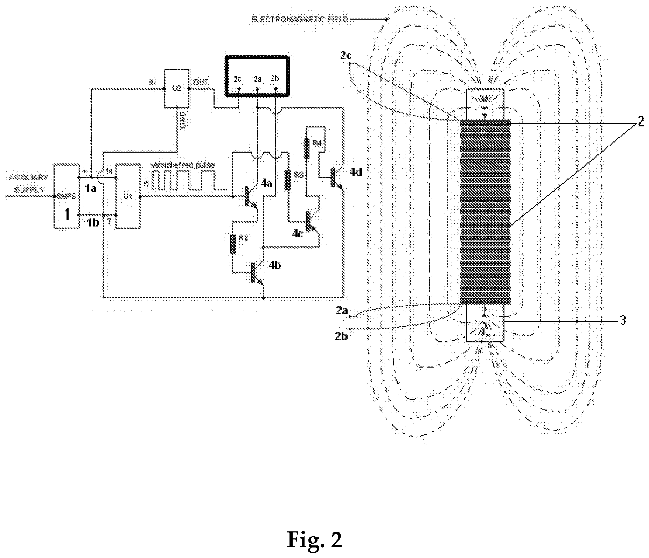

In an example as shown in Fig. 2, which can be used advantageously in connection with the present invention, for enhancing ranges of variable frequency of the electro-magnetic field, a plurality of transistors (4a, 4b, 4c, 4d) is utilized. For sake of understanding, the center tap (2c) and conductor leads (2a, 2b) are shown in the different box. In this embodiment, the transistors 4a, 4b and 4d, are BC337, 2N3904 and 2N2222, respectively, are NPN transistors and the transistor 4c, is BC327, and is a PNP transistor. As shown in Fig. 2, the DC signal from the SMPS is supplied to the center tap (2c) by passing through the regulator means (U1). After that, said signal is passed from said coils towards its conductor lead (2a) and conductor lead (2b). Here, the configuration of said transistor (4a, 4b, 4c and 4d) varies the frequency of electro-magnetic field in the manner discussed below.

As shown in Fig. 2, a timer (U2) receives signal from the SMPS and applied the signal by logic 0 and 1. Logic "0" present "low" signal and logic "1" present "high signal". When, the timer (U2) sends the logic 1, the transistor (4a) will be activated so that the signal from the terminal (2a) is applied to the base terminal of the transistor (4b) by passing through the resistor R2. Thus, transistor (4b) will be activated that allows the signal to pass from conductor lead (2b) to negative terminal (1b) of the SMPS. Likewise, when the timer (U2) sends logic 0, the transistor (4c) (PNP transistor) will be actuated so that signal from the conductor lead (2b) is applied to the base terminal of the transistor (4d). Thus, the transistor (4d) will be activated that enable the signal to pass from the conductor lead (2a) to negative terminal (1b) of the SMPS. Further, said timer chips (U2) sends pulses of logic "0" and logic "1" at irregular time intervals.

By said configuration, the frequency of electromagnetic field produced in the coils is varied in a broad range that is more effective for removing scale from the pipes. Here, the frequency of the magnetic field induced in the coils is varied in the range of 10Hz to 400Hz. Further, in the example, a modulated magnetic field is generated.

Thus, every time, the frequency and magnitude of electromagnetic field will be varied. Further, said timer (U2) is utilized to provide base current to the transistors which is much lower (i.e. in micro ampere) compared to current drawn from timer in R-L-C circuit. Hence, unlike R-L-C circuit, the timer doesn't get hot.

According to present invention, by variation in frequency of alternating electro-magnetic field, a multiple decrease in the amount of calcium in the deposit is achieved. Thus, formation of scale in the pipe is removed. Thus, the installation of the instant invention on the main water supply line of a residence may prevent the formation of scale within the piping system of the home.

The invention has been explained in relation to specific embodiment. It is inferred that the foregoing description is only illustrative of the present invention and it is not intended that the invention be limited or restrictive thereto. The extend of the invention is determined by the annexed set of claims.

## Claims

1. An apparatus for the removal and prevention of scale deposition comprising:

   a generator (1) having a positive terminal (1a) and a negative terminal (1b) for generating a DC signal between said terminals (1a, 1b);
   an elongated tubular member (3) configured to be interconnected with a water carrying conduit in an axial manner, having at a first end an inlet and at a second end longitudinally opposite the first end an outlet for the flowing fluid;
   at least one signal wire (2) being wrapped around said elongated member to form a first coil and a second coil; said wire having a conductor lead (2a, 2b) at its both ends; said first coil and said second coil having successive turns;
   at least one transistor (4) having three terminals, B, C and E, associated with the generator (1) for ensuring that the signal is non continuous and can be modulated with variable frequency;
   a resistor (R1);
   wherein said coils are overlapping each other and are electrically connected to each other thereby forming a center tap (2c);
   wherein said center tap (2c) is electrically connected with the positive terminal (1a) of the generator (1) so that a signal is applied to the coils to energize the coils and to generate a corresponding variable electromagnetic field in the conduit;
   wherein one of said conductor leads (2a) of the wire (2) is electrically connected to the terminal B of the transistor (4) via said resistor (R1);
   wherein the other one of said conductor leads (2b) of the wire (2) is electrically connected to the terminal C of the transistor (4);
   wherein the negative terminal (1b) of the generator (1) is electrically connected to the terminal E of the transistor (4);
   wherein said signal energizes said first coil and said second coil to produce an alternating magnetic field in said coils;

   wherein said transistor (4) is a NPN transistor having a characteristic of low operating frequency whereby it varies the frequency of said magnetic field induced in said first and second coils;
   wherein the NPN transistor has a heat sink;
   wherein the successive turns of each of said first and second coil are in opposite direction;
   wherein the two overlapped coils that are formed on the pipe contain a similar number of turns.

2. A method for the removal and prevention of scale deposition through the apparatus as claimed in claim 1 comprises following steps:

   a) winding a number of turns of said signal wire (2) around said elongated tubular member (3) to form said first coil and winding a number of turns on the first coil with same wire in opposite direction around said elongated tubular member (3) to form said second, overlapping, coil;
   b) forming said center tap (2c) at the connecting point oH4w said coils;
   c) electrically connecting said center tap (2c) with the positive terminal (1a) of the generator (1);
   d) electrically connecting one of the conductor lead(2a) of the signal wire (2) to the terminal B of the transistor (4) via said resistor (R1);
   e) electrically connecting one of the conductor lead (2b) of the signal wire to the terminal C of the transistor (4);
   f) electrically connecting the negative terminal (1b) of the generator (1) to the terminal E of the transistor (4);
   g) applying said signal through said electrical connections so as to pass through said first coil and second coil;
   h) producing an alternating magnetic field in said coils by applying said signal to said overlapped coils;
   i) varying the frequency of the magnetic field produced in said coils by said transistor (4) by interrupting said signal for effectively removing the scale.

## Patentansprüche

1. Vorrichtung zum Entfernen und Verhindern von Kesselsteinablagerungen, umfassend:

   einen Generator (1) mit einem positiven Anschluss (1a) und einem negativen Anschluss (1b) zum Generieren eines DC-Signals zwischen den Anschlüssen (1a, 1b);
   ein langgestrecktes röhrenförmiges Element (3), das so konfiguriert ist, dass es mit einer wasserführenden Leitung axial verbunden werden kann, und das an einem ersten Ende einen Einlass und an einem zweiten Ende, das dem ersten Ende in Längsrichtung gegenüberliegt, einen Auslass für das strömende Fluid aufweist; mindestens einen Signaldraht (2), der um das langgestreckte Element gewickelt ist, um eine erste Spule und eine zweite Spule zu bilden; wobei der Draht an seinen beiden Enden einen Leiteranschluss (2a, 2b) hat; wobei die erste Spule und die zweite Spule aufeinanderfolgende Windungen haben;
mindestens einen Transistor (4) mit drei Anschlüssen B, C und E, der mit dem Generator (1) verbunden ist, um sicherzustellen, dass das Signal nicht kontinuierlich ist und mit variabler Frequenz moduliert werden kann;
einen Widerstand (R1);
wobei die Spulen einander überlappen und elektrisch miteinander verbunden sind, wodurch ein Mittelabgriff (2c) gebildet wird,
wobei der Mittelabgriff (2c) elektrisch mit dem positiven Anschluss (1a) des Generators (1) verbunden ist, so dass ein Signal an die Spulen angelegt wird, um die Spulen zu erregen und ein entsprechendes variables elektromagnetisches Feld in der Leitung zu generieren;
wobei einer der Leiteranschlüsse (2a) des Drahtes (2) über den Widerstand (R1) elektrisch mit dem Anschluss B des Transistors (4) verbunden ist;
wobei der andere der Leiteranschlüsse (2b) des Drahtes (2) elektrisch mit dem Anschluss C des Transistors (4) verbunden ist;
wobei der negative Anschluss (1b) des Generators (1) elektrisch mit dem Anschluss E des Transistors (4) verbunden ist;
wobei das Signal die erste Spule und die zweite Spule erregt, um ein wechselndes Magnetfeld in den Spulen zu erzeugen;
wobei der Transistor (4) ein NPN-Transistor ist, der die Eigenschaft einer niedrigen Betriebsfrequenz hat, wodurch er die Frequenz des in der ersten und zweiten Spule induzierten Magnetfeldes variiert;
wobei der NPN-Transistor eine Wärmesenke aufweist;
wobei die aufeinanderfolgenden Windungen jeder der ersten und zweiten Spule in entgegengesetzter Richtung verlaufen;
wobei die beiden überlappenden Spulen, die auf dem Rohr ausgebildet sind, eine ähnliche Anzahl von Windungen aufweisen.

2. Verfahren zum Entfernen und Verhindern von Kesselsteinablagerungen durch die Vorrichtung nach Anspruch 1, das die folgenden Schritte umfasst:

a) Wickeln einer Anzahl von Windungen des Signaldrahtes (2) um das langgestreckte röhrenförmige Element (3), um die erste Spule zu bilden, und Wickeln einer Anzahl von Windungen auf die erste Spule mit demselben Draht in entgegengesetzter Richtung um das langgestreckte röhrenförmige Element (3) herum, um die zweite, überlappende Spule zu bilden;
b) Ausbilden des Mittelabgriffs (2c) an der Verbindungsstelle der Spulen;
c) elektrisches Verbinden des Mittelabgriffs (2c) mit dem positiven Anschluss (1a) des Generators (1);
d) elektrisches Verbinden eines der Leiteranschlüsse (2a) des Signaldrahtes (2) mit dem Anschluss B des Transistors (4) über den Widerstand (R1);
e) elektrisches Verbinden eines der Leiteranschlüsse (2b) des Signaldrahtes mit dem Anschluss C des Transistors (4);
f) elektrisches Verbinden des negativen Anschlusses (1b) des Generators (1) mit dem Anschluss E des Transistors (4);
g) Anlegen des Signals über die elektrischen Verbindungen, damit es durch die erste Spule und die zweite Spule läuft;
h) Erzeugen eines wechselnden Magnetfeldes in den Spulen durch Anlegen des Signals an die sich überlappenden Spulen;
i) Variieren der Frequenz des in den Spulen erzeugten Magnetfeldes durch den Transistor (4) durch Unterbrechung des Signals, um den Kesselstein effektiv zu entfernen.

## Revendications

1. Appareil destiné à l'élimination et la prévention d'un dépôt de tartre, comprenant :

un générateur (1) présentant une borne positive (1a) et une borne négative (1b) pour engendrer un signal à courant continu entre lesdites bornes (1a, 1b) ;
un élément tubulaire allongé (3) configuré pour être interconnecté d'une façon axiale avec un conduit acheminant de l'eau, comportant à une première extrémité une entrée et à une seconde extrémité, opposée longitudinalement à la première extrémité, une sortie pour le fluide s'écoulant ;
au moins un fil (2) de signal étant enroulé autour dudit élément allongé pour former une première bobine et une seconde bobine ; ledit fil comportant un fil conducteur (2a, 2b) à ses deux extrémités ; ladite première bobine et ladite seconde bobine présentant des spires successives ;
au moins un transistor (4) présentant trois bornes, B, C et E, associé au générateur (1) pour faire en sorte que le signal soit non continu et puisse être modulé avec une fréquence variable ;

une résistance (R1) ;

dans lequel lesdites bobines se chevauchent et sont connectées électriquement l'une à l'autre en formant une prise centrale (2c) ;

dans lequel ladite prise centrale (2c) est connectée électriquement à la borne positive (1a) du générateur (1) de sorte qu'un signal est appliqué sur les bobines pour mettre sous tension les bobines et pour engendrer dans le conduit un champ électromagnétique variable correspondant ;

dans lequel l'un desdits fils conducteurs (2a) du fil (2) est connecté électriquement à la borne B du transistor (4) via ladite résistance (R1) ;

dans lequel l'autre desdits fils conducteurs (2b) du fil (2) est connecté électriquement à la borne C du transistor (4) ;

dans lequel la borne négative (1b) du générateur (1) est connectée électriquement à la borne E du transistor (4) ;

dans lequel ledit signal met sous tension ladite première bobine et ladite seconde bobine pour produire un champ magnétique alternatif dans lesdites bobines ;

dans lequel ledit transistor (4) est un transistor NPN ayant une caractéristique de basse fréquence de fonctionnement lui permettant de faire varier la fréquence dudit champ magnétique induit dans lesdites première et seconde bobines ;

dans lequel le transistor NPN comporte un puits de chaleur ;

dans lequel les spires successives de chacune desdites première et seconde bobines sont en direction opposée ;

dans lequel les deux bobines chevauchantes qui sont formées sur le tuyau comportent un nombre semblable de spires.

2. Procédé pour l'élimination et la prévention d'un dépôt de tartre au moyen de l'appareil tel que revendiqué dans la revendication 1, comprenant les étapes suivantes, consistant à :

a) enrouler un certain nombre de spires dudit fil (2) de signal autour dudit élément tubulaire allongé (3) pour former ladite première bobine et enrouler un certain nombre de spires sur la première bobine avec le même fil en direction opposée autour dudit élément tubulaire allongé (3) pour former ladite seconde bobine chevauchante ;

b) former ladite prise centrale (2c) au point de connexion desdites bobines ;

c) connecter électriquement ladite prise centrale (2c) à la borne positive (1a) du générateur (1) ;

d) connecter électriquement l'un des fils conducteurs (2a) du fil (2) de signal à la borne B du transistor (4) via ladite résistance (R1) ;

e) connecter électriquement l'un des fils conducteurs (2b) du fil de signal à la borne C du transistor (4) ;

f) connecter électriquement la borne négative (1b) du générateur (1) à la borne E du transistor (4) ;

g) appliquer ledit signal par lesdites connections électriques de manière à le faire passer dans ladite première bobine et ladite seconde bobine ;

h) produire un champ magnétique alternatif dans lesdites bobines par application dudit signal sur lesdites bobines chevauchantes ;

i) faire varier la fréquence du champ magnétique produit dans lesdites bobines par ledit transistor (4) en interrompant ledit signal pour éliminer efficacement le tartre.

**Fig. 1**

**Fig. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013048569 A1